# EUROPÄISCHE PATENTSCHRIFT

(11) **EP 3 386 042 B1**
(45) Veröffentlichungstag und Bekanntmachung des Hinweises auf die Patenterteilung: **28.10.2020**
(21) Anmeldenummer: 18157785.9
(22) Anmeldetag: 21.02.2018
(51) Int. Cl.: H01S 5/02, H01S 5/024, F21S 45/47, H01S 5/022, F21S 41/16, F21S 41/19

(54) **VERFAHREN ZUR MONTAGE EINER LASERDIODE AUF EINEM KÜHLKÖRPER, NACH DIESEM VERFAHREN MONTIERTE LICHTAUSSENDUNGSEINHEIT UND KRAFTFAHRZEUGSCHEINWERFER MIT EINER SOLCHEN LICHTAUSSENDUNGSEINHEIT**
METHOD FOR MOUNTING A LASER DIODE ON A HEAT SINK, LIGHT EMITTING UNIT MOUNTED USING THIS METHOD AND MOTOR VEHICLE HEADLAMP WITH SUCH A LIGHT EMITTING UNIT
PROCÉDÉ DE MONTAGE D'UNE DIODE LASER SUR UN DISSIPATEUR THERMIQUE, UNITÉ D'ÉMISSION DE LUMIÈRE MONTÉE SELON LEDIT PROCÉDÉ ET PHARES DE VÉHICULE AUTOMOBILE POURVUS D'UNE TELLE UNITÉ D'ÉMISSION DE LUMIÈRE

(30) Priorität: 04.04.2017 DE 102017107197
(43) Veröffentlichungstag der Anmeldung: 10.10.2018
(73) Patentinhaber: Automotive Lighting Reutlingen GmbH, 72762 Reutlingen (DE)
(72) Erfinder: BRAUN, Stephan, 70771 Echterdingen (DE); NEUBAUER, Ulrich, 73235 Weilheim (DE); STOPPER, Ralf, 72108 Rottenburg am Neckar (DE); MÜRBETH, Moritz, 70329 Stuttgart (DE)
(74) Vertreter: DREISS Patentanwälte PartG mbB

(56) Entgegenhaltungen:
- US-A1- 2013 038 842
- US-A1- 2013 265 561
- US-A1- 2014 029 637

## Beschreibung

Die vorliegende Erfindung betrifft ein Verfahren zur Montage einer Laserdiode auf einem Kühlkörper Ferner betrifft die Erfindung eine Lichtaussendungseinheit umfassend eine Laserdiode und einen Kühlkörper, auf dem die Laserdiode montiert ist. Schließlich betrifft die vorliegende Erfindung auch einen Kraftfahrzeugscheinwerfer mit einer solchen Lichtaussendungseinheit nach dem Oberbegriff des Anspruchs 13. Solche Gegenstände sind aus den Druckschriften US 2014/0029637 A1, US 2013/0038842 A1 und US 2013/0265561 A1 bekannt. Laserdioden werden seit einigen Jahren verstärkt als Lichtquellen in Kraftfahrzeugscheinwerfern eingesetzt. Laserdioden bieten eine Reihe von vorteilhaften Eigenschaften, wie z.B. eine vergleichsweise kleine lichtaussendende Fläche, hohe Strahlungsintensitäten, sowie die Ausstrahlung von gut kollimierbaren Lichtbündeln. Optische Systeme für Laserlicht können daher mit kleineren Brennweiten aufgebaut werden, als optische Systeme für weniger stark kollimierte Lichtbündel von zum Beispiel Glühlampen oder Leuchtdioden (LEDs). Die optischen Systeme für Laserlicht lassen sich daher mit geringem Bauraum realisieren und sind deshalb für den Einsatz in Kraftfahrzeugscheinwerfern besonders gut geeignet.

Aufgrund der großen Hitzeentwicklung bei Laserdioden während ihres Betriebs, muss eine Laserdiode auf einem Kühlkörper montiert werden, über den Wärme von der Laserdiode abgeführt und die Betriebstemperatur der Laserdiode auf einen Wert verringert wird, bei dem keine Beeinträchtigung der Funktionsfähigkeit oder gar ein Defekt der Laserdiode droht. Die Laserdiode kann auf verschiedene Weisen auf dem Kühlkörper montiert werden.

Aus dem Stand der Technik ist es bspw. bekannt, zylindrische Laserdioden über einen Flansch, der an einer Außenumfangsfläche eines Gehäuses der Laserdiode ausgebildet ist, und eine Halteplatte mittels mehrerer Schrauben auf einem Halter zu befestigen, der gleichzeitig als Kühlkörper dient. Um während des Betriebs der Laserdiode ausreichend Wärme abführen zu können, ist eine ausreichende Haltekraft zwischen der Laserdiode und dem Kühlkörper erforderlich. Ferner sollte eine möglichst gleichmäßige Kraftverteilung zwischen der Halteplatte und dem Flansch vorliegen, um die Laserdiode sicher und zuverlässig in einer vorgegebenen Position zu halten und ein Verkippen der Laserdiode zu vermeiden. Deshalb sieht der Stand der Technik eine Vielzahl (mind. vier) umfangsseitig um die Laserdiode herum angeordneter Schrauben vor, mit denen die Halteplatte an dem Kühlkörper festgeschraubt und gleichzeitig die Laserdiode zwischen Halteplatte und Kühlkörper eingespannt wird.
Ausgehend von dem beschriebenen Stand der Technik liegt der vorliegenden Erfindung die Aufgabe zugrunde, ein Verfahren der eingangs genannten Art dahingehend auszugestalten und weiterzubilden, dass
- eine ausreichend große Haltekraft zwischen der Halteplatte und dem Kühlkörper bereitgestellt wird,
- eine möglichst gleichmäßige Haltekraft zwischen der Halteplatte und dem Kühlkörper bereitgestellt wird,
- ein Verkippen der Laserdiode verhindert wird,
- ein Ausgleich der Bauteiltoleranzen erzielt wird, und/oder
- ein Ausgleich der unterschiedlichen Wärmeausdehnung der verschiedenen Bauteile in der Lichtaussendungseinheit erzielt wird, so dass eine konstante Haltekraft bei Hoch- und Tieftemperaturlastfällen gegeben ist.

Zur Lösung dieser Aufgabe wird ein Verfahren mit den Merkmalen des Anspruchs 1 vorgeschlagen. Insbesondere wird vorgeschlagen, dass die Laserdiode ein Gehäuse mit einem zumindest über einen Teil einer Außenumfangsfläche des Gehäuses verlaufenden Flansch aufweist, und die Laserdiode mit den folgenden Schritten auf dem Kühlkörper montiert wird:
- die Laserdiode wird in oder auf eine Montageposition des Kühlkörpers gesetzt,
- ein die Laserdiode zumindest abschnittsweise umfassendes Halteelement wird von einer dem Kühlkörper abgewandten Seite der Laserdiode auf diese aufgesetzt, wobei sich das auf die Laserdiode aufgesetzte Halteelement zumindest mittelbar auf einer Oberseite des Flansches abstützt, die auf einer von dem Kühlkörper abgewandten Seite des Flansches ausgebildet ist,
- das Halteelement wird an dem Kühlkörper befestigt, und
- zwischen dem Halteelement und der Oberseite des Flansches des Gehäuses der Laserdiode wird ein elastisches Ausgleichselement angeordnet, das als ein Blechstanzteil ausgebildet ist, das einen ringförmigen Abschnitt mit einer zentralen Öffnung aufweist, deren Form einer Außenkontur des Gehäuses der Laserdiode auf einer von dem Kühlkörper abgewandten Seite des Flansches entspricht, das von dem ringförmigen Abschnitt radial nach außen abstehende Federzungen aufweist, die umfangsseitig gleichmäßig zueinander beabstandet angeordnet sind. Das Halteelement wird mittels zweier Schrauben an dem Kühlkörper befestigt, die auf einander gegenüberliegenden Seiten der Laserdiode angeordnet sind.

Das Halteelement ist vorzugsweise als eine Halteplatte ausgebildet. Die nachfolgenden auf eine Halteplatte gerichteten Erläuterungen gelten in entsprechender Weise auch für jede andere Art von Halteelement. Das elastische Ausgleichselement wirkt zwischen der Halteplatte und der Laserdiode. Es verteilt die Kraft der Halteplatte gleichmäßig auf den Flansch des Gehäuses der Laserdiode und sorgt so für eine konstante Haltekraft, mit der die Laserdiode auf den Kühlkörper gedrückt wird. Insbesondere wird eine konstante Anpresskraft zwischen etwa 50 N und 200 N erreicht. Das Ausgleichselement sorgt für eine gleichmäßige Anpresskraft über den gesamten Umfang der Laserdiode und wirkt so einem Verkippen der Laserdiode entgegen. Bauteiltoleranzen und unterschiedliche Wärmeausdehnung der Bauteile des Lichtaussendungselements können durch das elastische Ausgleichselement wirksam kompensiert werden.

Gemäß einer vorteilhaften Weiterbildung der vorliegenden Erfindung wird vorgeschlagen, dass im Rahmen der Montage der Laserdiode auf dem Kühlkörper das elastische Ausgleichselement von der von dem Kühlkörper abgewandten Seite der Laserdiode auf diese aufgesetzt wird, bevor die Halteplatte auf die Laserdiode aufgesetzt wird.

Erfindungsgemäß wird die Halteplatte mittels Schrauben an dem Kühlkörper befestigt. Entscheidend ist dabei, dass die Halteplatte und der Kühlkörper auf Anschlag geschraubt werden, was in der Fertigung ein gleichbleibendes Anschraubmoment gewährleistet. Dank des elastischen Ausgleichselements können weniger Schrauben als im Stand der Technik verwendet werden, da durch das Ausgleichselement die Anpresskraft des Halteelements gleichmäßig über den gesamten Umfang auf die Laserdiode übertragen wird und einem Verkippen aufgrund der Schraubenreihenfolge entgegengewirkt wird. Insbesondere wird vorgeschlagen, dass die Halteplatte mittels zweier Schrauben an dem Kühlkörper befestigt wird, die auf gegenüberliegenden Seiten der Laserdiode angeordnet sind. Dadurch ergibt sich eine Reduzierung des Schraubaufwands während der Montage.

Grundsätzlich ist die Schraubrichtung frei wählbar. Sie kann entweder von der von der Laserdiode abgewandten Seite oder von der Seite der Laserdiode verschraubt werden. Je nach gewählter Schraubrichtung muss die Schraubdomgeometrie dann im Kühlkörper oder in der Halteplatte abgebildet werden. Welche Lösung angewandt wird, ist von den Bauraumverhältnissen abhängig. Vorteilhafterweise werden die Schrauben von einer von der Laserdiode abgewandten Seite des Kühlkörpers durch entsprechende in dem Kühlkörper ausgebildete Öffnungen geführt und in entsprechenden Gewindebohrungen in der Halteplatte verschraubt, die auf der dem Kühlkörper zugewandten Seite der Halteplatte ausgebildet sind. Alternativ können statt der Gewindebohrungen auch ganz normale Öffnungen ohne Gewinde in der Halteplatte vorgesehen sein, wobei die Schrauben dann als Gewindefurchschrauben ausgebildet sind.

Die der vorliegenden Erfindung zugrundeliegende Aufgabe wird auch durch eine Lichtaussendungseinheit mit den Merkmalen des Anspruchs 5 gelöst. Demnach umfasst die Lichtaussendungseinheit eine Laserdiode und einen Kühlkörper, auf dem die Laserdiode montiert ist. Die Laserdiode weist ein Gehäuse mit einem zumindest über einen Teil einer Außenumfangsfläche des Gehäuses verlaufenden Flansch auf. Die Laserdiode stützt sich mit einer dem Kühlkörper zugewandten Seite des Gehäuses auf dem Kühlkörper ab. Die Laserdiode ist mittels einer Halteplatte auf dem Kühlkörper befestigt, welche die Laserdiode zumindest abschnittsweise umfasst. Die Halteplatte stützt sich zumindest mittelbar auf einer von dem Kühlkörper abgewandten Oberseite des Flansches auf diesem ab und ist an dem Kühlkörper befestigt. Zwischen der Halteplatte und der Oberseite des Flansches des Gehäuses ist ein elastisches Ausgleichselement angeordnet.
Der Halteflansch am Gehäuse der Laserdiode kann lediglich an mehreren zueinander umfangsseitig beabstandeten diskreten Abschnitten des Gehäuses ausgebildet sein. Vorteilhafterweise erstreckt sich der Flansch jedoch über den gesamten Umfang entlang der Außenseite des Gehäuses. Die Oberseite des Flansches, auf den die Halteplatte mittelbar über das elastische Ausgleichselement wirkt, steht vorzugsweise radial von der Umfangsfläche des Gehäuses der Laserdiode ab. Die Flächenerstreckung verläuft dabei vorzugsweise senkrechte zur Außenumfangsfläche des Gehäuses der Laserdiode. Die Laserdiode durch die Halteplatte mit ihrer Rückseite gegen eine entsprechende Montageposition des Kühlkörpers gedrückt. Dabei kann die Haltekraft besonders effizient zwischen der Halteplatte und dem Flansch (und damit dem Gehäuse bzw. der Laserdiode) wirken, da sich die Wirkfläche (Oberseite des Flansches) senkrecht zu der Haltekraft erstreckt.

Der Flansch auf der Außenumfangsseite des Gehäuses kann als ein einziger umlaufender Flansch oder aber in Form von mehreren über den Umfang verteilt und zueinander beabstandeten Flanschabschnitten ausgebildet sein. Es wäre denkbar, dass die Oberseiten von mehreren, über den Außenumfang des Gehäuses verteilt angeordneten, diskreten Flanschabschnitten auf einer gemeinsamen, senkrecht zu der Hauptabstrahlrichtung der Laserdiode verlaufenden Ebene angeordnet sind. In diesem Sinne wird vorgeschlagen, dass die Oberseite des Flansches (eines einzigen umlaufenden Flansches oder von mehreren diskreten Flanschabschnitten) eine Ebene definiert, die senkrecht zu einer Hauptabstrahlrichtung der Laserdiode verläuft.
Gemäß einer vorteilhaften Weiterbildung der Erfindung wird vorgeschlagen, dass das Gehäuse der Laserdiode eine zylindrische Form aufweist und sich der Flansch auf der Außenumfangsfläche des Zylinders erstreckt.

Das elastische Ausgleichselement ist als ein Blechstanzteil ausgebildet. Gemäß der Erfindung wird vorgeschlagen, dass das Ausgleichselement einen ringförmigen Abschnitt mit einer zentralen Öffnung aufweist, deren Form einer Außenkontur des Gehäuses der Laserdiode auf einer von dem Kühlkörper abgewandten Seite des Flansches entspricht. Der ringförmige Abschnitt stützt sich vorzugsweise auf einer von dem Kühlkörper abgewandten Seite des Flansches des Gehäuses der Laserdiode ab.
Des Weiteren wird vorgeschlagen, dass das elastische Ausgleichselement von dem ringförmigen Abschnitt radial abstehende Federzungen aufweist. Die Federzungen können sich in der durch den ringförmigen Abschnitt aufgespannten Ebene oder schräg dazu erstrecken. Distale Enden der Federzungen stützen sich vorzugsweise auf einer dem Kühlkörper zugewandten Seite der Halteplatte ab. In einem Montagezustand, in dem die Halteplatte, das elastische Ausgleichselement und der Kühlkörper relativ zueinander positioniert sind, aber die Halteplatte noch nicht an dem Kühlkörper befestigt ist (bspw. weil die Schrauben noch nicht angezogen sind), erstrecken sich die Federzungen derart schräg bezüglich der durch das ringförmige Element aufgespannten Ebene, dass die distalen Enden auf der von dem Flansch abgewandten Seite der Ebene angeordnet sind.

Schließlich wird zur Lösung der Aufgabe ein Kraftfahrzeugscheinwerfer mit den Merkmalen des Anspruchs 13 vorgeschlagen. Dieser umfasst ein Gehäuse mit einer durch eine transparente Abdeckscheibe verschlossenen Lichtaustrittsöffnung, wobei in dem Gehäuse ein Laserlichtmodul zur Erzeugung einer Scheinwerferfunktion oder eines Teils davon angeordnet ist. Das Laserlichtmodul umfasst eine erfindungsgemäße Lichtaussendungseinheit nach einem der Ansprüche 5 bis 12.

Weitere Merkmale und Vorteile der vorliegenden Erfindung werden nachfolgend anhand der Figuren näher erläutert. Es zeigen:
- Figur 1: einen erfindungsgemäßen Kraftfahrzeugscheinwerfer gemäß einer bevorzugten Ausführungsform;
- Figur 2: eine erfindungsgemäße Lichtaussendungsanordnung gemäß einer bevorzugten Ausführungsform in einem montierten Zustand in einer Schnittansicht;
- Figur 3: die Lichtaussendungsanordnung aus Figur 2 in einer Explosionsdarstellung; und
- Figur 4: ein Ablaufdiagramm des erfindungsgemäßen Verfahrens gemäß einer bevorzugten Ausführungsform.

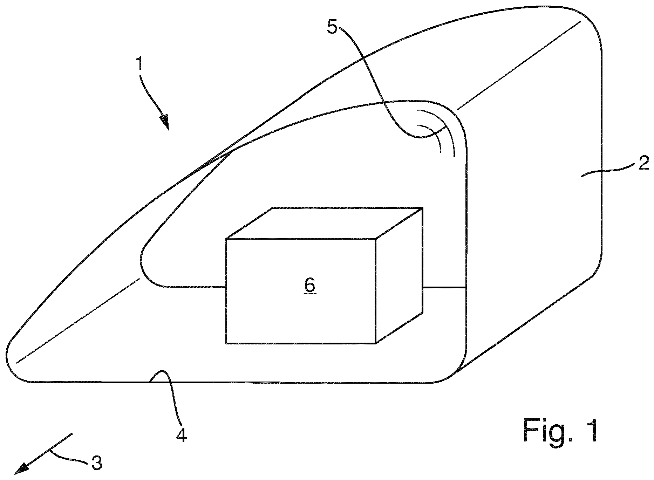

Ein erfindungsgemäßer Kraftfahrzeugscheinwerfer 1 ist beispielhaft in Figur 1 gezeigt und dient zur Erzeugung einer vorgegebenen Lichtverteilung. Die Lichtverteilung kann eine beliebige Scheinwerferfunktion sein, bspw. Abblendlicht, Fernlicht, Nebellicht oder eine beliebigen adaptiven Lichtverteilung (z.B. Teilfernlicht) oder ein Teil davon. Es ist auch denkbar, dass die von dem Scheinwerfer 1 erzeugte Lichtverteilung ein Hinweis (z.B. Symbol) zur Information eines Fahrers des Kraftfahrzeugs oder von im Umfeld des Kraftfahrzeugs befindlichen Personen über bestimmte Umgebungs- und/oder Fahrzeugsituationen ist, der auf der Fahrbahn vor dem Kraftfahrzeug abgebildet wird. Der Hinweis kann bspw. ein Verkehrsschild (zur Warnung des Fahrers vor bestimmten Gefahrensituationen), ein stilisierter Fußgänger (zur Warnung des Fahrers vor Fußgängern am Straßenrand), ein Zebrastreifen (zur Information von Fußgängern, dass das Kraftfahrzeug anhält und die Fahrbahn überquert werden kann), ein Eiskristall (zur Warnung des Fahrers vor glatter Fahrbahn), oder ein Abbiegehinweis (z.B. Pfeil) eines Navigationssystems sein.

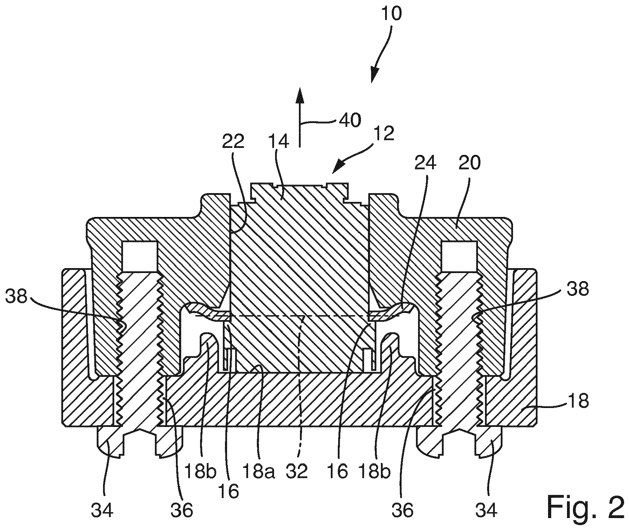

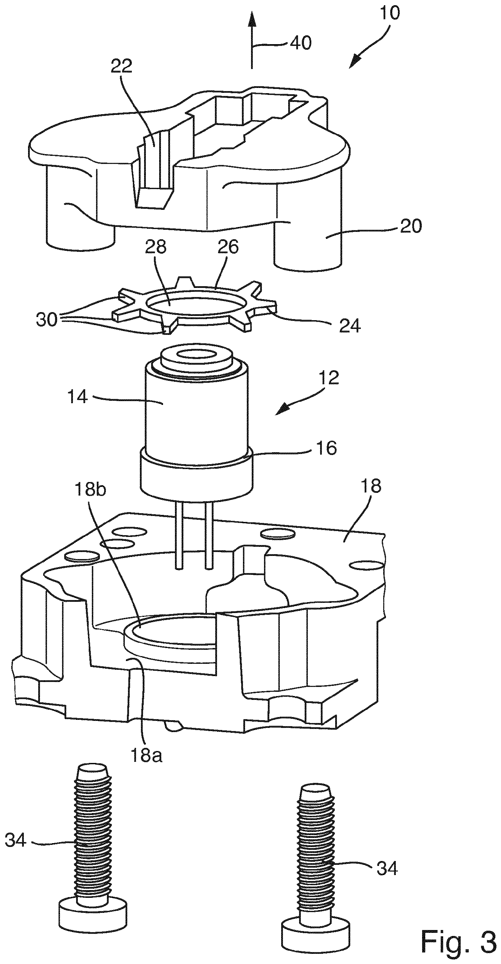

Der Scheinwerfer 1 umfasst ein Gehäuse 2, das vorzugsweise aus einem lichtundurchlässigen Material, insbesondere Kunststoff besteht. In einer Lichtaustrittsrichtung 3 weist das Gehäuse 2 eine Lichtaustrittsöffnung 4 auf, die durch eine Abdeckscheibe 5 verschlossen ist. Die Abdeckscheibe 5 besteht vorzugsweise aus einem transparenten Material, bspw. Glas oder Kunststoff. Die Abdeckscheibe 5 kann zumindest bereichsweise mit optisch wirksamen Elementen (bspw. Prismen oder Zylinderlinsen) versehen sein, um das hindurchtretende Licht zu streuen (sog. Streuscheibe). Vorzugsweise ist die Abdeckscheibe 5 jedoch auch ohne optisch wirksame Elemente ausgebildet (sog. klare Scheibe). An einer lediglich schematisch eingezeichneten Position 6 ist im Inneren des Gehäuses 2 ein Lichtmodul angeordnet, das eine Lichtaussendungseinheit 10 (vgl. Figuren 2 und 3) zum Aussenden von kollimiertem Laserlicht und eine Optikeinheit (nicht dargestellt) zum Abbilden des Laserlichts als die resultierende Lichtverteilung des Lichtmoduls auf der Fahrbahn vor dem Fahrzeug umfasst. Das Lichtmodul 6 ist bspw. als ein Laserlichtmodul mit einer als Laserdiode 12 (vgl. Figuren 2 und 3) ausgebildeten Lichtquelle. Das Lichtmodul 6 dient zur Erzeugung der Lichtverteilung des Scheinwerfers 1 oder eines Teils der Lichtverteilung. Die Lichtaussendungseinheit wird nachfolgend anhand der Figuren 2 und 3 näher erläutert. Der Scheinwerfer 1 ist an einer beliebigen Stelle an der Außenseite vorzugsweise im Frontbereich des Kraftfahrzeugs, insbesondere in einer dafür vorgesehenen Einbauöffnung der Fahrzeugkarosserie, angeordnet und befestigt.

Im Rahmen der vorliegenden Erfindung sollen unter dem Begriff 'Laserdiode 12' ein Bauteil verstanden werden, das als Lichtquelle einen Laserdiodenchip (Halbleiterchip, der für die Lichterzeugung verantwortlich ist) aufweist, der in einem Gehäuse 14 angeordnet ist. In dem Gehäuse 14 der Laserdiode 12 kann neben dem Laserdiodenchip auch eine Linse und/oder ein Konverter angeordnet sein. In einer bevorzugten Ausführungsform ist in dem Gehäuse ein Laserdiodenchip angeordnet, in dessen Lichtstrahl eine Linse und ein Konverter angeordnet sind. Das blaue Laserlicht, das von dem Laserdiodenchip erzeugt wird, wird mit einer Linse auf den Konverter gebündelt. Der Konverter ist ausgebildet, zumindest einen Teil des blauen Lichts in gelbes Licht zu konvertieren. Durch Überlagerung von nicht konvertiertem blauen Laserlicht und konvertiertem gelben Licht ergibt sich weißes Licht, welches das Gehäuse 14 in der Lichtaustrittsrichtung 40 verlässt.

Ein bevorzugtes Ausführungsbeispiel einer Lichtaussendungseinheit 10 ist beispielhaft in Figur 2 im Schnitt und in Figur 3 in einer Explosionsdarstellung gezeigt. Die Lichtaussendungseinheit 10 umfasst eine Laserdiode 12, die in diesem Beispiel ein zylindrisches Gehäuse 14 hat. Die Laserdiode 12 dient zum Aussenden von kollimiertem Laserlicht in eine Hauptabstrahlrichtung 40. An der Außenseite des Gehäuses 14 ist ein Flansch 16 ausgebildet, der sich vorzugsweise um die gesamte Gehäuseaußenseite erstreckt. Selbstverständlich wäre es aber auch denkbar, dass der Flansch 16 mehrere umfangsseitig zueinander beabstandete, diskrete Flanschabschnitte aufweist. Die Laserdiode 12 wird nach dem erfindungsgemäßen Verfahren auf einem Kühlkörper 18 montiert. Bei dem Kühlkörper 18 kann es sich um einen passiven Kühlkörper handeln, der seine Wärme einfach über Konvektion an die Umgebung abgibt, unter Umständen mit Hilfe eines Gebläses. Der Kühlkörper 18 könnte aber auch aktiv gekühlt werden, bspw. mittels Kühlmittelleitungen im Inneren des Kühlkörpers, durch die eine Kühlflüssigkeit fließt, oder mittels eines Peltierelements. Andere Möglichkeiten zur aktiven Kühlung des Kühlkörpers 18 sind ebenfalls denkbar.

Auf der Oberseite (der der Laserdiode 12 zugewandten Seite) des Kühlkörpers 18 ist eine Montageposition 18a ausgebildet, die eine Auflagefläche umfasst, die vorzugsweise dem Flächenverlauf der Unterseite (der zum Kühlkörper 18 gerichteten Seite) der Laserdiode 12 entspricht. Die Montageposition 18a kann außen um die Auflagefläche herum durch eine kragenförmige Begrenzung 18b umgeben sein. Zur Montage ist ein Halteelement 20 vorgesehen, das vorzugsweise als eine Halteplatte ausgebildet ist. Die nachfolgenden Ausführungen bezüglich einer Halteplatte 20 gelten in entsprechender Weise auch für jede andere Art von Halteelement. Die Halteplatte 20 umfasst die Laserdiode 12 von außen zumindest abschnittsweise. Vorzugsweise umfasst die Halteplatte 20 die Laserdiode 12 über ihren gesamten Umfang. Deshalb weist die Halteplatte 20 in diesem Beispiel eine Öffnung 22 auf, deren Form der Außenkontur des Gehäuses 14 oberhalb (auf der von dem Kühlkörper 18 abgewandten Seite) des Flansches 16 entspricht.

Zwischen der Halteplatte 20 und dem Flansch 16 ist ein elastisches Ausgleichselement 24 angeordnet. Das Ausgleichselement 24 weist in diesem Beispiel einen ringförmigen Abschnitt 26 mit einer zentralen Öffnung 28 auf, deren Form der Außenkontur des Gehäuses 14 der Laserdiode 12 oberhalb des Flansches 16 entspricht. Der ringförmige Abschnitt 26 stützt sich auf einer vom Kühlkörper 18 abgewandten Seite des Flansches 16 des Gehäuses 14 ab. Ferner umfasst das Ausgleichselement 24 von dem ringförmigen Abschnitt 26 radial abstehende Federzungen 30 auf. In dem Beispiel sind sieben umfangsseitig gleichmäßig zueinander beabstandete Federzungen 30 vorgesehen. Selbstverständlich können auch weniger oder mehr Federzungen vorgesehen sein. Distale Enden der Federzungen 30 stützen sich auf einer dem Kühlkörper 18 zugewandten Seite der Halteplatte 20 ab. Der ringförmige Abschnitt 26 definiert eine Ebene 32 (vgl. Figur 2). Die Federzungen 30 können sich in dieser Ebene erstrecken. In dem gezeigten Beispiel erstrecken sich die Federzungen 30 ausgehend von dem ringförmigen Abschnitt 26 jedoch schräg nach oben, so dass die distalen Enden der Federzungen 30 oberhalb (auf der von dem Kühlkörper 18 abgewandten Seite) der Ebene 32 angeordnet sind.

Die Oberseite (von dem Kühlkörper 18 abgewandte Seite) des Flansches 16 verläuft vorzugsweise senkrecht zu der Außenfläche des Gehäuses 14. Die Oberseite des Flansches 16 definiert eine Ebene, die vorzugsweise senkrecht zu einer Hauptabstrahlrichtung 40 der Laserdiode 10 und damit im Wesentlichen parallel zu der Ebene 32 verläuft.

Die Halteplatte 20 ist an dem Kühlkörper 18 befestigt. In dem gezeigten Beispiel ist sie mittels Schrauben 34 an dem Kühlkörper 18 befestigt. Grundsätzlich ist die Schraubrichtung frei wählbar. Sie kann entweder von der von der Laserdiode 12 abgewandten Seite oder von der Seite der Laserdiode 12 her verschraubt werden. Je nach gewählter Schraubrichtung muss die Schraubdomgeometrie dann im Kühlkörper 18 oder in der Halteplatte 20 abgebildet werden. Welche Lösung angewandt wird, ist von den Bauraumverhältnissen abhängig. In dem vorliegenden Beispiel sind zwei Schrauben 34 auf gegenüberliegenden Seiten der Laserdiode 12 vorgesehen. Selbstverständlich können auch mehr als die gezeigten zwei Schrauben verwendet werden. Die Schrauben 34 sind von unten (von einer von der Laserdiode 12 abgewandten Seite des Kühlkörpers 18) durch entsprechende in dem Kühlkörper 18 ausgebildete Öffnungen 36 hindurch geführt und in entsprechenden Gewindebohrungen 38 in der Halteplatte 20 verschraubt. Die Gewindebohrungen 18 sind an der Unterseite (auf der dem Kühlkörper 18 zugewandten Seite) der Halteplatte 20 ausgebildet. Alternativ können statt der Gewindebohrungen 38 auch normale Öffnungen ohne Gewinde an der Unterseite der Halteplatte 20 ausgebildet sein, in die als Gewindefurchschrauben ausgebildete Schrauben 34 eingedreht werden.

Die Halteplatte 20 und der Kühlkörper 18 sind auf Anschlag geschraubt. Dadurch ist in der Fertigung ein gleichbleibendes Anschraubmoment gewährleistet. Zwischen der Halteplatte 20 und der Laserdiode 12 ist ein Spiel vorhanden. Dieses Spiel wird durch das elastische Ausgleichselement 24 kompensiert, wodurch im Verbau eine umlaufende Anpresskraft von etwa minimal 50 N und maximal 200 N auf den Flansch 16 aufgebracht wird. Wenn die Halteplatte 20 fest an dem Kühlkörper 18 befestigt ist, bspw. durch Anziehen der Schrauben 34, ist zwischen der Halteplatte 20 und der Laserdiode 12 ein Spalt ausgebildet, in dem das elastische Ausgleichselement 24 angeordnet ist. Die Höhe des Spalts ist geringer als die Höhe des elastischen Ausgleichselements 24. Das heißt, beim Befestigen der Halteplatte 20 an dem Kühlkörper 18 verkleinert sich der Spalt und das Ausgleichselement 24 wird entgegen einer Federkraft elastisch zusammengedrückt.

Ein Verkippen aufgrund der Schraubreihenfolge ist nicht möglich. Für die Fertigung von besonderem Vorteil ist dabei die lageunabhängige Verbaubarkeit des elastischen Ausgleichselements 24. Das Ausgleichselement 24 kompensiert Bauteiltoleranzen und gleicht unterschiedliche Wärmeausdehnungen der Bauteile der Lichtaussendungseinheit 10 aus.

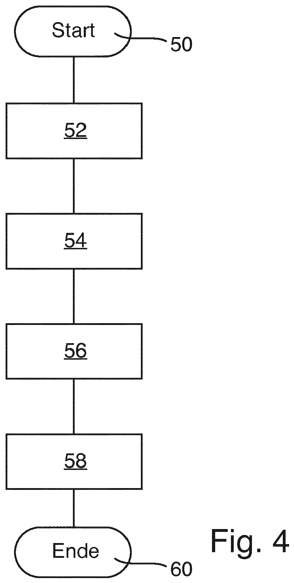

Die erfindungsgemäße Lichtaussendungseinheit 10 wird nach dem erfindungsgemäßen Verfahren montiert, das nachfolgend unter Bezugnahme auf die Figur 4 näher erläutert wird. Das Verfahren beginnt in einem Funktionsblock 50. Dann wird in einem Funktionsblock 52 die Laserdiode 12 in oder auf die Montageposition 18a des Kühlkörpers 18 gesetzt. Anschließend wird in einem Funktionsblock 54 das elastische Ausgleichselement 24 von oben (von einer vom Kühlkörper 18 abgewandten Seite der Laserdiode 12 aus) auf die Laserdiode 12 aufgesetzt. Dabei nimmt die Öffnung 28 des ringförmigen Abschnitts 26 des Ausgleichselements 24 die Laserdiode 12 auf und umgibt ihr Gehäuse 14 auf der Außenumfangsseite. Des Weiteren wird dann in einem Funktionsblock 56 die Halteplatte 20 von oben auf die Laserdiode 12 aufgesetzt, wobei die Laserdiode 12 von der Öffnung 22 der Halteplatte 20 aufgenommen wird. Die auf die Laserdiode 12 aufgesetzte Halteplatte 20 stützt sich mittelbar über das elastische Ausgleichselement 24 auf einer Oberseite des Flansches 16 des Gehäuses 14 der Laserdiode 12 ab. Die Oberseite des Flansches 16 ist auf einer von dem Kühlkörper 18 abgewandten Seite des Flansches 16 ausgebildet. Abschließend wird in einem Funktionsblock 58 die Halteplatte 20 an dem Kühlkörper 18 befestigt. Dies erfolgt in dem beschriebenen Beispiel mittels der Schrauben 34. Durch Anziehen der Schrauben 34 liegen eine Unterseite der Halteplatte 20 und eine Oberseite des Kühlkörpers 18 unmittelbar auf Anschlag aufeinander. Zwischen der Oberseite des Flansches 16 und der entsprechenden Unterseite der Halteplatte 24 ist ein Spalt ausgebildet, in dem das elastische Ausgleichselement 24 angeordnet ist. Die Anpresskraft, die durch die Halteplatte 20 auf die Laserdiode 12 ausgeübt wird, wird durch das Ausgleichselement 24 gleichmäßig über den gesamten Umfang des Flansches 16 verteilt. In einem Funktionsblock 60 ist das Verfahren dann beendet.

## Patentansprüche

1. Verfahren zur Montage einer Laserdiode (12) auf einem Kühlkörper (18), wobei die Laserdiode (12) ein Gehäuse (14) mit einem zumindest über einen Teil einer Außenumfangsfläche des Gehäuses (14) verlaufenden Flansch (16) aufweist, wobei
die Laserdiode (12) in oder auf eine Montageposition (18a) des Kühlkörpers (18) gesetzt wird,
ein die Laserdiode (12) zumindest abschnittsweise umfassendes Halteelement (20) von einer von dem Kühlkörper (18) abgewandten Seite der Laserdiode (12) auf diese aufgesetzt wird,
sich das auf die Laserdiode (12) aufgesetzte Halteelement (20) zumindest mittelbar auf einer Oberseite des Flansches (16) abstützt, die auf einer von dem Kühlkörper (18) abgewandten Seite des Flansches (16) ausgebildet ist, und
das Halteelement (20) an dem Kühlkörper (18) befestigt wird,
**wobei** zwischen dem Halteelement (20) und der Oberseite des Flansches (16) des Gehäuses (14) der Laserdiode (12) ein elastisches Ausgleichselement (24) angeordnet wird, wobei das Ausgleichselement (24) als ein Blechstanzteil ausgebildet ist, das einen ringförmigen Abschnitt (26) mit einer zentralen Öffnung (28) aufweist, deren Form einer Außenkontur des Gehäuses (14) der Laserdiode (12) auf einer von dem Kühlkörper (18) abgewandten Seite des Flansches (16) entspricht, dass das elastische Ausgleichselement (24) von dem ringförmigen Abschnitt (26) radial nach außen abstehende Federzungen (30) aufweist, die umfangsseitig gleichmäßig zueinander beabstandet angeordnet sind und dass das Halteelement (20) mittels zweier Schrauben (34) an dem Kühlkörper (18) befestigt wird, die auf einander gegenüberliegenden Seiten der Laserdiode (12) angeordnet sind.

2. Verfahren nach Anspruch 1, **dadurch gekennzeichnet, dass** das elastische Ausgleichselement (24) von der von dem Kühlkörper (18) abgewandten Seite der Laserdiode (12) auf diese aufgesetzt wird, bevor das Halteelement (20) auf die Laserdiode (12) aufgesetzt wird.
sind.

3. Verfahren nach Anspruch 1 oder 2, **dadurch gekennzeichnet, dass** die Schrauben (34) von einer von der Laserdiode (12) abgewandten Seite des Kühlkörpers (18) durch entsprechende in dem Kühlkörper (18) ausgebildete Öffnungen (36) geführt und in entsprechenden Gewindebohrungen (38) in dem Halteelement (20) verschraubt werden, die auf der dem Kühlkörper (18) zugewandten Seite des Halteelements (20) ausgebildet sind.

4. Verfahren nach Anspruch 1 oder 2, **dadurch gekennzeichnet, dass** die Schrauben (34) als Gewindefurchschrauben ausgebildet sind, die von einer von der Laserdiode (12) abgewandten Seite des Kühlkörpers (18) durch entsprechende in dem Kühlkörper (18) ausgebildete Öffnungen (36) geführt und in entsprechenden Öffnungen in dem Halteelement (20) verschraubt werden, die auf der dem Kühlkörper (18) zugewandten Seite des Halteelements (20) ausgebildet sind.

5. Lichtaussendungseinheit (10) umfassend eine Laserdiode (12) und einen Kühlkörper (18), auf dem die Laserdiode (12) montiert ist, wobei die Laserdiode (12) ein Gehäuse (14) mit einem zumindest über einen Teil einer Außenumfangsfläche des Gehäuses (14) verlaufenden Flansch (16) aufweist und die Laserdiode (12) sich mit einer dem Kühlkörper (18) zugewandten Seite des Gehäuses (14) auf dem Kühlkörper (18) abstützt, und wobei die Laserdiode (12) mittels eines Halteelements (20) auf dem Kühlkörper (18) montiert ist, welches die Laserdiode (12) zumindest abschnittsweise umfasst, welches sich zumindest mittelbar auf einer von dem Kühlkörper (18) abgewandten Oberseite des Flansches (16) auf diesem abstützt und welches an dem Kühlkörper (18) befestigt ist, wobei zwischen dem Halteelement (20) und der Oberseite des Flansches (16) des Gehäuses (14) der Laserdiode (12) ein elastisches Ausgleichselement (24) angeordnet ist, wobei das Ausgleichselement (24) als ein Blechstanzteil ausgebildet ist, das einen ringförmigen Abschnitt (26) mit einer zentralen Öffnung (28) aufweist, deren Form einer Außenkontur des Gehäuses (14) der Laserdiode (12) auf einer von dem Kühlkörper (18) abgewandten Seite des Flansches (16) entspricht, dass das elastische Ausgleichselement (24) von dem ringförmigen Abschnitt (26) radial nach außen abstehende Federzungen (30) aufweist, die umfangsseitig gleichmäßig zueinander beabstandet angeordnet sind, und dass das Halteelement (20) mittels zweier Schrauben (34) an dem Kühlkörper (18) befestigt wird, die auf einander gegenüberliegenden Seiten der Laserdiode (12) angeordnet sind.

6. Lichtaussendungseinheit (10) nach Anspruch 5, **dadurch gekennzeichnet, dass** sich der Flansch (16) um die gesamte Außenumfangsfläche des Gehäuses (14) herum erstreckt.

7. Lichtaussendungseinheit (10) nach Anspruch 5 oder 6, **dadurch gekennzeichnet, dass** das Gehäuse (14) der Laserdiode (12) eine zylindrische Form aufweist und sich der Flansch (16) auf der Außenumfangsfläche des Zylinders erstreckt.

8. Lichtaussendungseinheit (10) nach einem der Ansprüche 5 bis 7, **dadurch gekennzeichnet, dass** die Oberseite des Flansches (16) eine Ebene definiert, die senkrecht zu einer Hauptabstrahlrichtung (40) der Laserdiode (10) verläuft.

9. Lichtaussendungseinheit (10) nach einem der Ansprüche 5 bis 8, **dadurch gekennzeichnet, dass** das Ausgleichselement (24) einen ringförmigen Abschnitt (26) mit einer zentralen Öffnung (28) aufweist, deren Form einer Außenkontur des Gehäuses (14) der Laserdiode (12) auf einer von dem Kühlkörper (18) abgewandten Seite des Flansches (16) entspricht.

10. Lichtaussendungseinheit (10) nach Anspruch 9, **dadurch gekennzeichnet, dass** sich der ringförmige Abschnitt (26) auf einer von dem Kühlkörper (18) abgewandten Seite des Flansches (16) des Gehäuses (14) der Laserdiode (12) abstützt.

11. Lichtaussendungseinheit (10) nach Anspruch 9 oder 10, **dadurch gekennzeichnet, dass** das elastische Ausgleichselement (24) von dem ringförmigen Abschnitt (26) radial abstehende Federzungen (30) aufweist.

12. Lichtaussendungseinheit (10) nach Anspruch 11, **dadurch gekennzeichnet, dass** sich distale Enden der Federzungen (30) auf einer dem Kühlkörper (18) zugewandten Seite des Halteelements (20) abstützen.

13. Kraftfahrzeugscheinwerfer (1) umfassend ein Gehäuse (2) mit einer durch eine transparente Abdeckscheibe (5) verschlossenen Lichtaustrittsöffnung (4), wobei in dem Gehäuse (2) ein Laserlichtmodul (6) zur Erzeugung einer Scheinwerferfunktion oder eines Teils davon angeordnet ist, **dadurch gekennzeichnet, dass** das Laserlichtmodul (6) eine Lichtaussendungseinheit (10) nach einem der Ansprüche 5 bis 12 umfasst.

## Claims

1. Method for mounting a laser diode (12) on a heat sink (18), the laser diode (12) having a housing (14) with a flange (16) extending at least over part of an outer circumferential surface of the housing (14), wherein the laser diode (12) is placed in or on a mounting position (18a) of the heat sink (18),
a holding element (20) surrounding the laser diode (12) at least in sections is placed on the laser diode (12) from a side of the laser diode (12) facing away from the heat sink (18),
the holding element (20) placed on the laser diode (12) is supported at least indirectly on an upper side of the flange (16), which is formed on a side of the flange (16) facing away from the heat sink (18), and
the holding element (20) is fixed to the heat sink (18), an elastic compensating element (24) being arranged between the holding element (20) and the top side of the flange (16) of the housing (14) of the laser diode (12), the compensating element (24) being designed as a sheet-metal stamped part which has an annular section (26) with a central opening (28) whose shape corresponds to an outer contour of the housing (14) of the laser diode (12) on a side of the flange (16) facing away from the heat sink (18), in that the elastic compensating element (24) has spring tongues (30) which project radially outwards from the annular section (26) and are arranged circumferentially at a uniform distance from one another, and in that the holding element (20) is fastened to the heat sink (18) by means of two screws (34) which are arranged on opposite sides of the laser diode (12).

2. Method according to claim 1, **characterized in that** the elastic compensating element (24) is placed on the laser diode (12) from the side of the laser diode (12) facing away from the heat sink (18) before the holding element (20) is placed on the laser diode (12).

3. Method according to claim 1 or 2, **characterized in that** the screws (34) are guided from a side of the heat sink (18) facing away from the laser diode (12) through corresponding openings (36) formed in the heat sink (18) and are screwed into corresponding threaded holes (38) in the holding element (20), which are formed on the side of the holding element (20) facing the heat sink (18).

4. Method according to claim 1 or 2, **characterized in that** the screws (34) are designed as threaded through screws which are guided from a side of the heat sink (18) facing away from the laser diode (12) through corresponding openings (36) formed in the heat sink (18) and are screwed into corresponding openings in the holding element (20) which are formed on the side of the holding element (20) facing the heat sink (18).

5. Light emitting unit (10) comprising a laser diode (12) and a heat sink (18) on which the laser diode (12) is mounted, wherein the laser diode (12) has a housing (14) with a flange (16) extending over at least part of an outer circumferential surface of the housing (14), and the laser diode (12) is supported on the heat sink (18) with a side of the housing (14) facing the heat sink (18), and the laser diode (12) is supported on the heat sink (18) with a side of the housing (14) facing the heat sink (18) wherein the laser diode (12) is mounted on the heat sink (18) by means of a holding element (20), which encompasses the laser diode (12) at least in sections, which is supported at least indirectly on a top side of the flange (16) facing away from the heat sink (18) and which is attached to the heat sink (18), wherein an elastic compensating element (24) is arranged between the holding element (20) and the upper side of the flange (16) of the housing (14) of the laser diode (12), wherein the compensating element (24) is designed as a sheet metal stamped part having an annular section (26) with a central opening (28) whose shape corresponds to an outer contour of the housing (14) of the laser diode (12) on a side of the flange (16) facing away from the heat sink (18), in that the elastic compensating element (24) has spring tongues (30) which project radially outwards from the annular section (26) and are arranged circumferentially at a uniform distance from one another, and in that the holding element (20) is fastened to the heat sink (18) by means of two screws (34) which are arranged on opposite sides of the laser diode (12).

6. Light emitting unit (10) according to claim 5, **characterized in that** the flange (16) extends around the entire outer circumferential surface of the housing (14).

7. Light emitting unit (10) according to claim 5 or 6, **characterized in that** the housing (14) of the laser diode (12) has a cylindrical shape and the flange (16) extends on the outer circumferential surface of the cylinder.

8. Light emitting unit (10) according to any one of claims 5 to 7, **characterized in that** the top surface of the flange (16) defines a plane perpendicular to a main emission direction (40) of the laser diode (10).

9. Light emitting unit (10) according to one of the claims 5 to 8, **characterized in that** the compensating element (24) has an annular section (26) with a central opening (28) whose shape corresponds to an outer contour of the housing (14) of the laser diode (12) on a side of the flange (16) facing away from the heat sink (18).

10. Light emitting unit (10) according to claim 9, **characterized in that** the annular section (26) is supported on a side of the flange (16) of the housing (14) of the laser diode (12) facing away from the heat sink (18).

11. Light emitting unit (10) according to claim 9 or 10, **characterized in that** the elastic compensating element (24) has spring tongues (30) projecting radially from the annular portion (26).

12. Light emitting unit (10) according to claim 11, **characterised in that** distal ends of the spring tongues (30) are supported on a side of the holding element (20) facing the heat sink (18).

13. Motor vehicle headlamp (1) comprising a housing (2) with a light exit opening (4) closed by a transparent cover lens (5), a laser light module (6) for generating a headlamp function or part thereof being arranged in the housing (2), **characterized in that** the laser light module (6) comprises a light emission unit (10) according to one of claims 5 to 12.

## Revendications

1. Procédé de montage d'une diode laser (12) sur un dissipateur thermique (18), dans lequel la diode laser (12) présente un boîtier (14) avec une bride (16) s'étendant au moins sur une partie d'une surface périphérique extérieure du boîtier (14), dans lequel
la diode laser (12) est placée dans ou sur une position de montage (18a) du dissipateur thermique (18),
un élément de retenue (20) englobant au moins par section la diode laser (12) est posé sur celle-ci depuis un côté de la diode laser (12) opposé au dissipateur thermique (18),
l'élément de retenue (20) posé sur la diode laser (12) s'appuie au moins indirectement sur un côté supérieur de la bride (16), qui est réalisé sur un côté de la bride (16) opposé au dissipateur thermique (18), et
l'élément de retenue (20) est fixé au dissipateur thermique (18),
dans lequel un élément de compensation (24) élastique est agencé entre l'élément de retenue (20) et le côté supérieur de la bride (16) du boîtier (14) de la diode laser (12), l'élément de compensation (24) étant réalisé en tant que pièce en tôle découpée, qui présente une section annulaire (26) avec une ouverture centrale (28) dont la forme correspond à un contour extérieur du boîtier (14) de la diode laser (12) sur un côté de la bride (16) opposé au dissipateur thermique (18), l'élément de compensation (24) élastique présentant des languettes élastiques (30) en saillie radiale vers l'extérieur depuis la section annulaire (26), qui sont agencées espacées l'une de l'autre uniformément en périphérie, et l'élément de retenue (20) étant fixé sur le dissipateur thermique (18) au moyen de deux vis (34) qui sont agencées sur des côtés opposés de la diode laser (12).

2. Procédé selon la revendication 1, **caractérisé en ce que** l'élément de compensation (24) élastique est posé sur la diode depuis le côté opposé au dissipateur thermique (18) de la diode laser (12), avant que l'élément de retenue (20) soit posé sur la diode laser (12).

3. Procédé selon la revendication 1 ou 2, **caractérisé en ce que** les vis (34) sont guidées depuis un côté opposé à la diode laser (12) du dissipateur thermique (18) à travers des ouvertures (36) correspondantes réalisées dans le dissipateur thermique (18) et sont vissées dans l'élément de retenue (20) dans des trous taraudés (38) correspondants, qui sont réalisés sur le côté de l'élément de retenue (20) opposé au dissipateur thermique (18) .

4. Procédé selon la revendication 1 ou 2, **caractérisé en ce que** les vis (34) sont réalisées en tant que vis auto-taraudeuses, qui sont guidées depuis un côté du dissipateur thermique (18) opposé à la diode laser (12) à travers des ouvertures (36) correspondantes réalisées dans le dissipateur thermique (18) et sont vissées dans l'élément de retenue (20), dans des ouvertures correspondantes qui sont réalisées sur le côté de l'élément de retenue (20) opposé au dissipateur thermique (18) .

5. Unité d'émission de lumière (10) comprenant une diode laser (12) et un dissipateur thermique (18) sur lequel la diode laser (12) est montée, dans laquelle la diode laser (12) présente un boîtier (14) avec une bride (16) s'étendant au moins sur une partie d'une surface périphérique extérieure du boîtier (14), et la diode laser (12) s'appuie sur le dissipateur thermique (18) par un côté du boîtier (14) tourné vers le dissipateur thermique (18), et dans laquelle la diode laser (12) est montée sur le dissipateur thermique (18) au moyen d'un élément de retenue (20), qui englobe au moins par section la diode laser (12), qui s'appuie sur celui-ci et au moins indirectement sur un côté supérieur de la bride (16) opposé au dissipateur thermique (18) et est fixé au dissipateur thermique (18), dans laquelle un élément de compensation (24) élastique est agencé entre l'élément de retenue (20) et le côté supérieur de la bride (16) du boîtier (14) de la diode laser (12), l'élément de compensation (24) étant réalisé en tant que pièce en tôle découpée, qui présente une section annulaire (26) avec une ouverture centrale (28) dont la forme correspond à un contour extérieur du boîtier (14) de la diode laser (12) sur un côté de la bride (16) opposé au dissipateur thermique (18), l'élément de compensation (24) élastique présentant des languettes élastiques (30) en saillie radiale vers l'extérieur depuis la section annulaire (26), qui sont agencées espacées l'une de l'autre uniformément en périphérie, et l'élément de retenue (20) étant fixé au dissipateur thermique (18) au moyen de deux vis (34) qui sont agencées sur des côtés opposés de la diode laser (12).

6. Unité d'émission de lumière (10) selon la revendication 5, **caractérisée en ce que** la bride (16) s'étend autour de toute la surface périphérique extérieure du boîtier (14).

7. Unité d'émission de lumière (10) selon la revendication 5 ou 6, **caractérisée en ce que** le boîtier (14) de la diode laser (12) présente une forme cylindrique et la bride (16) s'étend sur la surface périphérique extérieure du cylindre.

8. Unité d'émission de lumière (10) selon l'une des revendications 5 à 7, **caractérisée en ce que** le côté supérieur de la bride (16) définit un plan qui s'étend perpendiculairement à une direction de rayonnement principale (40) de la diode laser (10).

9. Unité d'émission de lumière (10) selon l'une des revendications 5 à 8, **caractérisée en ce que** l'élément de compensation (24) présente une section annulaire (26) avec une ouverture centrale (28) dont la forme correspond à un contour extérieur du boîtier (14) de la diode laser (12) sur un côté de la bride (16) opposé au dissipateur thermique (18).

10. Unité d'émission de lumière (10) selon la revendication 9, **caractérisée en ce que** la section annulaire (26) s'appuie sur un côté opposé au dissipateur thermique (18) de la bride (16) du boîtier (14) de la diode laser (12).

11. Unité d'émission de lumière (10) selon la revendication 9 ou 10, **caractérisée en ce que** l'élément de compensation (24) élastique présente des languettes élastiques (30) en saillie radiale depuis la section annulaire (26).

12. Unité d'émission de lumière (10) selon la revendication 11, **caractérisée en ce que** les extrémités distales des languettes élastiques (30) s'appuient sur un côté de l'élément de retenue (20) tourné vers le dissipateur thermique (18).

13. Phare de véhicule automobile (1) comprenant un boîtier (2) avec une ouverture de sortie de lumière (4) fermée par une vitre de recouvrement (5) transparente, dans lequel un module de lumière laser (6) destiné à la génération d'une fonction de phare ou d'une partie de celle-ci est agencé dans le boîtier (2), **caractérisé en ce que** le module de lumière laser (6) comprend une unité d'émission de lumière (10) selon l'une des revendications 5 à 12.
